(19) Europäisches Patentamt
European Patent Office
Office européen des brevets

(11) EP 2 259 052 A1

(12) # EUROPEAN PATENT APPLICATION
published in accordance with Art. 153(4) EPC

(43) Date of publication:
**08.12.2010 Bulletin 2010/49**

(21) Application number: **09718730.6**

(22) Date of filing: **10.03.2009**

(51) Int Cl.:
***G01N 24/08*** *(2006.01)* ***C08J 5/22*** *(2006.01)*

(86) International application number:
**PCT/JP2009/054986**

(87) International publication number:
**WO 2009/113706 (17.09.2009 Gazette 2009/38)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **11.03.2008 JP 2008060810**

(71) Applicant: **Sumitomo Chemical Company, Limited
Tokyo 104-8260 (JP)**

(72) Inventors:
- **KAWATA, Takefumi
Tsukuba-shi
Ibaraki 305-0821 (JP)**
- **KANESAKA, Sho
Tsukuba-shi
Ibaraki 305-0821 (JP)**

(74) Representative: **Vossius & Partner
Siebertstrasse 4
81675 München (DE)**

(54) **METHOD FOR DISCRIMINATING POLYMER FILMS**

(57) A method for discriminating a polymer compound membrane, the method having selecting a polymer compound membrane which shows little time-dependent change in a relaxation time (T1ρ) when the T1ρ of the polymer compound membrane has been measured by using a solid-state NMR device with a magnetic field strength of 7.05 Tesla.

EP 2 259 052 A1

## Description

TECHNICAL FIELD

The present invention relates to a method for discriminating a polymer compound membrane which shows little shrinkage due to environmental changes.

BACKGROUND ART

Polymer compound membranes are used in a variety of applications such as light-shielding films, ambient air-shielding films, conductive films, semiconductor films, ion-permeable films, and light-emitting films. When a polymer compound membrane is under an environment undergoing repeated water absorption and drying, or repeated temperature changes, shrinkage is generally generated, and if the shrinkage ratio is large, a problem occurs in that the polymer compound membrane is distorted.

Therefore, a polymer compound membrane which shows little shrinkage due to environmental changes is sought; however, a polymer compound membrane which shows little shrinkage has been obtained only by discriminating one which is small in shrinkage ratio by investigating through trial and error the composition of a polymer compound for constituting a polymer compound membrane, additives added thereto, and the like, and performing a test of environmental changes for a prepared polymer compound membrane. Therefore, there has been a demand for a method for simply and easily discriminating a polymer compound membrane which shows little shrinkage without carrying out a test on environmental changes.

DISCLOSURE OF INVENTION

An object of the present invention is to provide a method for simply and easily discriminating a polymer compound membrane which shows little shrinkage due to the environmental changes without carrying out a test of environmental change.

The present inventors made extensive studies on a method of discrimination by means of solid-state NMR without carrying out an environmental test in order to solve the above-described problems, and as a result, they have found that the time-dependency of the relaxation time (T1ρ) in heating has a correlation with the shrinkage of a polymer compound membrane, thereby accomplishing the present invention.

Specifically, the present invention provides the following <1> to <9>.

<1> A method for discriminating a polymer compound membrane, the method comprising selecting a polymer compound membrane which shows little time-dependent change in a relaxation time (T1ρ) when the T1ρ of the polymer compound membrane has been measured by using a solid-state NMR device with a magnetic field strength of 7.05 Tesla.

<2> The method for discriminating a polymer compound membrane according to <1>, wherein the T1ρ is a T1ρ (ms) of a 13C nucleus at a temperature of 80°C measured by using a solid-state NMR device with a magnetic field strength of 7.05 Tesla, the method comprising selecting a polymer compound membrane in which the coefficient a of formula (1) satisfies formula (2) when the change in the T1ρ (ms) relative to a time t (hour) having elapsed since the start of measurement is represented by formula (1):

$$T1\rho = a \times \ln(t) + b \qquad (1)$$

$$0 \leq a \leq 25 \qquad (2).$$

<3> A polymer compound membrane, wherein the coefficient a of formula (1) satisfies formula (2) when the T1ρ (ms) of the polymer compound membrane at a temperature of 80°C is measured by using a solid-state NMR device with a magnetic field strength of 7.05 Tesla, and the change in the T1ρ (ms) relative to a time t (hour) having elapsed since the start of measurement is represented by formula (1):

$$T1\rho = a \times \ln(t) + b \qquad (1)$$

$$0 \leq a \leq 25 \qquad (2).$$

<4> The polymer compound membrane according to <3> comprising a polymer compound constituting an engineering plastic.
<5> The polymer compound membrane according to <3> or <4> comprising a polymer having an ion-exchange group.
<6> The polymer compound membrane according to any one of <3> to <5> comprising a block copolymer comprising at least one blocks having an ion-exchange group and at least one blocks having no ion-exchange group.
<7> The polymer compound membrane according to any one of <3> to <6> comprising a block copolymer comprising one or more blocks having an aromatic group in the main chain or a side chain and having an ion-exchange group, and one or more blocks having an aromatic group in the main chain or a side chain and having no ion-exchange group.
<8> The polymer compound membrane according to any one of <3> to <7> comprising a polyarylene-based block copolymer comprising one or more blocks having at least one kind of ion-exchange group selected from the group consisting of a phosphonic acid group, a carboxylic acid group, a sulfonic acid group, and a sulfonimide group, and one or more blocks having no ion-exchange group.
<9> A method for producing a polymer electrolyte membrane, the method comprising applying a solution containing a polymer electrolyte to a substrate by cast-application and removing a solvent to obtain the polymer electrolyte membrane, wherein in the solvent-removing step, the specific humidity H of the atmosphere of the step is kept in a range satisfying $0.01 \leq H \leq 0.5$ and the Celsius temperature T of the atmosphere of the step is kept in a range satisfying formula (3):

$$100 \leq T \leq 160 \qquad (3).$$

BEST MODE FOR CARRYING OUT THE INVENTION

The method for discriminating a polymer compound membrane of the present invention is characterized by selecting a polymer compound membrane which shows little time-dependent change in a relaxation time (T1ρ) when the T1ρ of the polymer compound membranes has been measured by using a solid-state NMR device with a magnetic field strength of 7.05 Tesla.

The discrimination method of the present invention can be applied to a polymer compound membrane comprising organic polymer compounds such as a polyolefin, PVA, a polymer compound to constitute an engineering plastic, and a protein, particularly can be preferably applied to a polymer compound membrane comprising a polymer compound to constitute an engineering plastic. Further, particularly, the discrimination method can be suitably applied to a polymer compound membrane having an ion-exchange group.

Examples of the engineering plastic include polyethersulfone, polyphenylenesulfide, polyetheretherketone, LCP, fluorine resin, polyethemitrile, polysulfone, polyarylate, and polyimide. Particularly among these, the discrimination method can be suitably applied to a polymer compound membrane comprising polyethersulfone.

Examples of the polyethersulfone include polymer compounds comprising a repeating unit represented by the following formula:

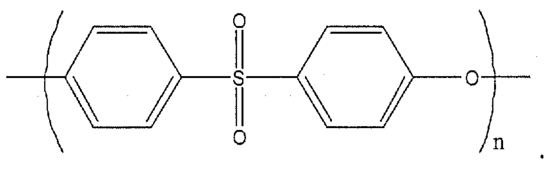

Provided as an example is one having one or more sites having an ion-exchange group and one or more sites having substantially no ion-exchange group, and being capable of developing a microphase-separated structure composed of at least two phases including a region in which sites having an ion-exchange group are mainly aggregated and a region in which sites having substantially no ion-exchange group are mainly aggregated upon conversion into the form of a membrane.

Examples of the polymer compound that tends to be microphase-separated into two or more phases include a block copolymer comprising one or more blocks having an aromatic group in the main chain or a side chain and having

an ion-exchange group, and one or more blocks having an aromatic group in the main chain or a side chain and having no ion-exchange group, for example, as a mixture.

Examples of the aromatic group include divalent monocyclic aromatic groups, such as a 1,3-phenylene group and a 1,4-phenylene group; divalent condensed ring aromatic groups, such as a 1,3-naphthalenediyl group, a 1,4-naphthalenediyl group, a 1.5-naphthalenediyl group, a 1,6-naphthalenediyl group, a 1,7-naphthalenediyl group, a 2,6-naphthalenediyl group and a 2,7-naphthalenediyl group; divalent aromatic heterocyclic groups, such as a pyridinediyl group, quinoxalinediyl group and a thiophenediyl group.

The polymer compound which can be suitably applied to the present invention may have the aromatic group in any of the main chain and a side chain, but from the viewpoint of the stability of an electrolyte membrane, it preferably has the aromatic group in the main chain. When the polymer compound has the aromatic group in the main chain, the polymer compound may form a polymer main chain by covalent bonding of a carbon or nitrogen atom contained in an aromatic ring or form a polymer main chain via carbon, or boron, oxygen, nitrogen, silicon, sulfur, phosphorous, or the like being outside an aromatic ring, but from the viewpoint of the water resistance of a polymer electrolyte membrane, a polymer in which a polymer main chain is formed by covalent bonding of a carbon or nitrogen atom contained in an aromatic ring or a polymer chain is formed by linking aromatic groups via a sulfone group (-$SO_2$-), a carbonyl group (-CO-), an ether group (-O-), an amide group (-NH-CO-), or an imide group represented by formula ($) is preferable. Further, the same polymer main chains or different polymer chains may be used for blocks having an ion-exchange group and blocks having no ion-exchange group.

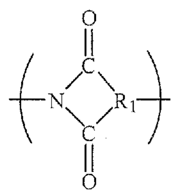

($)

wherein $R_1$ represents an alkyl group, an aryl group, or the like.

Herein, the "ion-exchange group" refers to a group that concerns ion conductivity, particularly proton conductivity when the polymer compound is used in the form of a membrane, "having an ion-exchange group" means that the number of the ion-exchange groups contained per repeating unit is about 0.5 or more on an average, and "having substantially no ion-exchange group" means that the number of the ion-exchange groups contained per repeating unit is about 0.1 or less on an average. Such an ion-exchange group may be any one of a cation-exchange group (hereinafter sometimes referred to as acidic group) or an anion-exchange group (hereinafter sometimes referred to as basic group).

While the acidic group includes acid groups such as weak acids group, strong acid groups and super strong acid groups, strong acid groups and super strong acid groups are preferable. Examples of the acidic group include weak acid groups, such as a phosphonic acid group and a carboxylic acid group; and strong acid groups, such as a sulfonic acid group and a sulfonimide group (-$SO_2$-NH-$SO_2$-$R_2$, wherein $R_2$ represents a monovalent substituent such as an alkyl group, an aryl group, and the like); and preferably used among these are a sulfonic acid group or a sulfonimide group, which are strong acid groups. Further, it is desirable to make the above strong acid group function as a super strong acid group by the effect of an electron withdrawing group such as a fluorine atom by replacing a hydrogen atom on a substituent (-$R_2$) of the aromatic ring and/or the sulfonimide group by an electron withdrawing group such as a fluorine atom.

These ion-exchange groups may be used singly or two or more ion-exchange groups may be used together. If two or more ion-exchange groups are used, although not limited, polymers having different ion-exchange groups may be blended and a polymer having two or more kinds of ion-exchange groups in the polymer introduced by such a method as copolymerization may be used. In addition, the ion-exchange groups may have formed salts by being replaced partly or entirely by metal ions or quaternary ammonium ions, and in the case of being used as, for example, a polymer electrolyte membrane for a fuel cell, it is preferable that the ion-exchange groups be in a state where substantially no ion-exchange groups have formed salts.

Examples of the aryl group referred to above include aryl groups, such as a phenyl group, a naphthyl group, a phenanthrenyl group and an anthracenyl group; aryl groups composed of the foregoing aryl groups substituted with a fluorine atom, a hydroxyl group, a nitrile group, an amino group, a methoxy group, an ethoxy group, an isopropyloxy group, a phenyl group, a naphthyl group, a phenoxy group, a naphthyloxy group, or the like.

[Measurement of Relaxation Time T1ρ of Carbon 13]

As for the polymer compound membrane used in the present investigation, its relaxation time T1ρ of carbon 13 (hereinafter sometimes referred to as 13C) was measured in accordance with the method described below.

As the measurement method was used a method comprising performing CP (cross-polarization) to transfer the magnetization of 1H to 13C and then spin-locking the magnetization. While a lock time τ of magnetization is varied to such a time that the signal intensity is sufficiently attenuated, measurement is performed at multiple points and the signals of 13C after a time τ are observed.

A signal intensity I (τ) to be obtained can be represented by the following formula:

$$I(\tau)=\exp(-\tau/T1\rho) \qquad (4)$$

The area of the signal of a chemical shift corresponding to the main chain of the polymer compound in the spectrum obtained is plotted against the lock time τ, and a T1ρ is determined by least-square fitting.

In the discrimination method of the present invention selected is a polymer compound membrane having little change against the time having elapsed since the start of measurement of the T1ρ (ms) as measured above. It is thought that the T1ρ of the main chain of a polymer compound has a correlation with the degree of freedom of the movement of the polymer chain in the peripheral space of the polymer. Further, it is thought that a polymer compound with a large time-dependent change of T1ρ is one such that the peripheral space of the polymer has shrunk, and therefore the shrinkage of a membrane due to environmental changes is large, while it can be thought that a polymer compound with a small time-dependent change of T1ρ has a little space in the periphery of the polymer and the peripheral space of the polymer does not change greatly even if the environment changes, and therefore the shrinkage of a membrane becomes small.

The change in the T1ρ (ms) relative to the time having elapsed since the start of measurement may be determined by calculating the ratio of the T1ρ values of at least two points including one point within 10 hours from the start of measurement, or calculating the difference of the T1ρ values, or by approximation using a specific formula indicating the time dependency.

For example, when the T1ρ is a T1ρ (ms) measured by solid-state NMR at a temperature of 80°C, and the change in the T1ρ (ms) relative to a time t (hour) having elapsed since the start of measurement is represented by formula (1), discrimination can be done by selecting a polymer compound membrane in which the coefficient a of formula (1) satisfies formula (2):

$$T1\rho = a\times\ln(t) + b \qquad (1)$$

$$0 \leq a \leq 25 \qquad (2)$$

wherein the coefficients a and b in formula (1) can be determined by applying a least-square method to T1ρ and the logarithm of the time t (hour) having elapsed since the start of measurement.

Particularly, a polymer compound membrane comprising a polymer compound to constitute an engineering plastic, wherein the coefficient a of formula (1) provided above satisfies formula (2) provided above when a T1ρ (ms) at a temperature of 80°C of the polymer compound membrane is measured by solid-state NMR and the change in the T1ρ (ms) relative to a time t (hour) having elapsed since the start of measurement is represented by formula (1), has a small shrinkage ratio due to environmental changes, and therefore, it can be suitably used as a light-shielding film, an ambient air-shielding film, a conductive film, a semiconductor film, or an ion-permeable film. In particular, a membrane selected by the discrimination method is useful for ion-permeable film applications, particularly for fuel cell applications because of its small shrinkage ratio due to environmental changes.

[Method for Producing Polymer Compound Membrane]

Next, in the present discrimination method, a method for producing a polymer compound membrane which shows a small shrinkage ratio upon water absorption or drying, or at a high temperature will be described.

A polymer compound membrane can be produced by applying, to a prescribed substrate, a solution prepared

by dissolving a polymer compound in a solvent and, if necessarily, adding an additive (applying step), evaporating the solvent from a film of the applied solution to remove it (solvent-evaporating and removing step), and performing washing with a poor solvent of the polymer compound membrane (washing step).

Herein, the present inventors has found that regarding a polymer compound membrane comprising a polymer compound to constitute an engineering plastic which is produced via the applying step and the solvent-evaporating and removing step, a polymer compound membrane which shows little shrinkage due to environmental changes can be obtained by setting the heating temperature in a conventional solvent-evaporating and removing step higher.

Particularly, for polymer compound membranes comprising polyethersulfone, heating has been performed at 60 to 100°C in the solvent-evaporating and removing step, but a polymer compound membrane which shows a small shrinkage ratio due to environmental changes can be obtained by performing heating at 120 to 160°C. The thus obtained polymer compound membrane is one such that the coefficient a of formula (1) provided previously satisfies formula (2) provided previously when the T1ρ (ms) of a 13C nucleus at a temperature of 80°C is measured by using a solid-state NMR device with a magnetic field strength of 7.05 Tesla, and the change in the T1ρ (ms) relative to a time t (hour) having elapsed since the start of measurement is represented by formula (1).

The polymer compound membrane may be formed on a substrate.

Preferred as the material of the substrate on which the solution is applied is a material which is chemically stable and is insoluble in the solvent to be used. In addition, more preferred as the substrate is one such that after the formation of a polymer compound membrane, the resulting membrane can be easily washed and easily peeled therefrom. Examples of such a substrate include plates, films, and the like each being made of glass, polytetrafluoroethylene, polyethylene, or polyester (polyethylene terephthalate and the like).

Preferred as a solvent to be used for a solution comprising the polymer compound is one which can dissolve the polymer compound and can be easily removed by evaporation after application. Such a suitable solvent can be appropriately selected according to, for example, the chemical structure of the polymer.

The solvent can be selected from, for example, among aprotic polar solvents, such as N,N-dimethylformamide, N,N-dimethylacetamide, N-methyl-2-pyrrolidone, and dimethylsulfoxide; chlorine-containing solvents, such as dichloromethane, chloroform, 1,2-dichloroethane, chlorobenzene, and dichlorobenzene; alcohol solvents, such as methanol, ethanol, and propanol; alkylene glycol monoalkyl ether solvents, such as ethylene glycol monomethyl ether, ethylene glycol monoethyl ether, propylene glycol monomethyl ether, and propylene glycol monoethyl ether. These may be used singly or two or more of them may be used in combination.

Hereinbelow, the present invention will be described in more detail with reference to Examples, but the present invention is not intended to be limited to these Examples.

(Example 1)

(Synthesis Example 1)

A polymer compound 1 was obtained which had sulfonic acid group-containing segments composed of repeating units represented by the following formula:

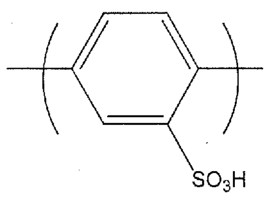

,

and segments having no ion-exchange group, represented by the following formula:

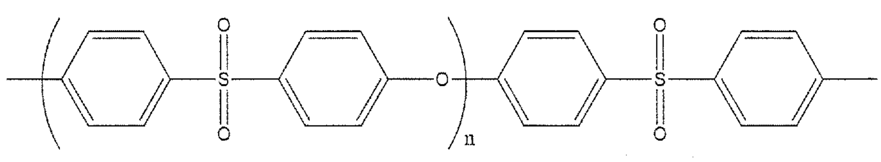

.

and which was synthesized by using SUMIKAEXCEL PES 5200P (manufactured by Sumitomo Chemical Co., Ltd.) with reference to the method described in Examples 7 and 21 of the pamphlet of International Publication WO2007/043274.

The polymer compound 1 was dissolved in dimethylsulfoxide to prepare a solution having a concentration of 10% by weight. From the obtained solution was produced an about 30 μm thick polymer compound membrane by using a supporting substrate (PET film, manufactured by Toyobo Co., Ltd., E5000 grade with a thickness of 100 μm) under conditions of a temperature of 140°C and a specific humidity of 0.122 kg/kg. The specific humidity refers to the amount of water vapor contained in a unit mass of wet air, wherein the amount of water vapor in 1 kg of air is expressed in kg. This film was immersed in 2 N sulfuric acid for 2 hours, then washed with ion-exchange water again, and further air-dried to produce a polymer compound membrane 1.

(Measurement of Relaxation Time T1ρ of 13C)

Measurement was conducted by using anAvance300 manufactured by Bruker Co., Ltd. A sample that had been left still at 25°C was finely cut, filled into a sample tube for measurement having an outer diameter of 4 mm, which was inserted into a device set at 25°C, and rotated at 12000 revolutions per second (12 kHz). The sample having reached thermal equilibrium was heated to 80°C and then measurement was begun. The signal for CH of adamantane was used as a chemical shift standard and it was determined as being 29.5 ppm.

Measurement was conducted under a static magnetic field strength of 7.05 T (Tesla) with resonance frequencies of 1H and 13C of 300 MHz and 75.4 MHz, respectively. As the measurement method was used a method comprising performing CP (cross-polarization) to transfer the magnetization of 1H to 13C and then spin-locking the magnetization. This magnetization transfer time (contact time) was set to 3 ms. The lock time τ of magnetization was varied between 0.100 and 120 msec and measurement was carried out at 6 to 8 points. The signals of 13C after a time τ were observed (high-power decoupling was performed in order to eliminate the effect of the dipole interaction by 1H during the observation. Further, in order to increase the S/N ratio, accumulation was made between 160 to 480 times). In addition, the repetition time was set to 8 sec.

The area of the signals at 160 ppm of the spectrum obtained was plotted against the lock time τ, and T1ρ was determined by least-square fitting.

As a result of the measurement of the relaxation time T1ρ of the polymer compound membrane 1, the time rate of change, a, was 20.4.

(Measurememt of Linear Expansion Coefficient upon Drying after Water-Absorption)

The obtained polymer compound membrane was cut into a square which was 3 cm on each side. In the center of the square, a square which was 2 cm on each side was marked. The dimension (Li) at this time and the dimension (Ld) when the membrane was allowed to absorb water and swell at 80°C for one hour and then dried under vacuum at 60°C for one hour were each measured, and calculated and determined as follows.

$$\text{Rate of dimensional change } [\%] = (Ld - Li) \div Li \times 100\ [\%]$$

The rate of dimensional change of the polymer compound membrane 1 which had been allowed to absorb water and then dried was 0.2%.

(Example 2)

A polymer compound synthesized according to Synthesis Example 1 was dissolved in dimethylsulfoxide to prepare a solution having a concentration of 10% by weight. From the obtained solution was produced an about 30 μm thick polymer compound membrane by using an a supporting substrate (PET film, manufactured by Toyobo Co., Ltd., E5000 grade with a thickness of 100 μm) under conditions of a temperature of 120°C and a specific humidity of 0.130 kg/kg. This film was immersed in 2 N sulfuric acid for 2 hours, then washed with ion-exchange water again, and further air-dried to produce a polymer compound membrane 2. The formed polymer compound membrane 2 was subjected to measurement of the relaxation time T1ρ by solid-state NMR, and as a result, the time rate of change, a, was 6.4. The rate of dimensional change of the polymer compound membrane 2 which had been allowed to absorb water and then dried was -1.4%.

(Example 3)

(Synthesis Example 2)

A polymer compound 2 was obtained which had sulfonic acid group-containing segments containing repeating units represented by the following formula:

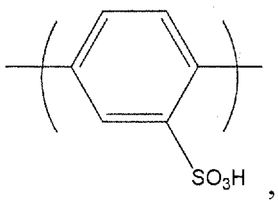

and segments having no ion-exchange group, represented by the following formula:

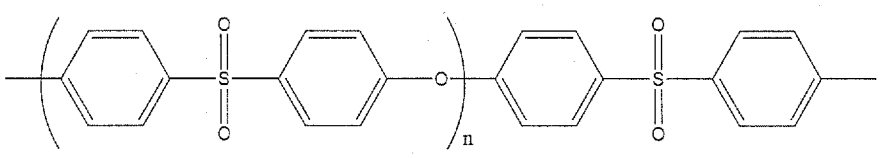

and which was synthesized by using SUMIKAEXCEL PES 5200P (manufactured by Sumitomo Chemical Co., Ltd.) with reference to the method described in Examples 7 and 21 of the pamphlet of International Publication WO2007/043274.

The polymer compound 2 was dissolved in dimethylsulfoxide to prepare a solution having a concentration of 10% by weight. From the obtained solution was produced an about 30 μm thick polymer compound membrane by using a supporting substrate (PET film, manufactured by Toyobo Co., Ltd., E5000 grade with a thickness of 100 μm) under conditions of a temperature of 150°C and a specific humidity of 0.120 kg/kg. This film was immersed in 2 N sulfuric acid for 2 hours, then washed with ion-exchange water again, and further air-dried to produce a polymer compound membrane 3. The polymer compound membrane 3 formed was subjected to measurement of the relaxation time T1ρ by solid-state NMR, and as a result, the time rate of change, a, was 14.1. The rate of dimensional change of the polymer compound membrane 3 which had been allowed to absorb water and then dried was -0.5%.

(Comparative Example 1)

The polymer compound synthesized according to Synthesis Example 1 was dissolved in dimethylsulfoxide to prepare a solution having a concentration of 10% by weight. From the obtained solution was produced an about 30 μm thick polymer compound membrane by using a supporting substrate (PET film, manufactured by Toyobo Co., Ltd., E5000 grade with a thickness of 100 μm) under conditions of a temperature of 80°C and a specific humidity of 0.103 kg/kg. This film was immersed in 2 N sulfuric acid for 2 hours, then washed with ion-exchange water again, and further air-dried to produce a polymer compound membrane 3. The polymer compound membrane 3 formed was subjected to measurement of the relaxation time T1ρ by solid-state NMR, and as a result, the time rate of change, a, was 31.1. The rate of dimensional change of the polymer compound membrane 2 which had been allowed to absorb water and then dried was -9.4%.

INDUSTRIAL APPLICABILITY

According to the method for discriminating a polymer compound membrane of the present invention, a polymer compound membrane which shows little shrinkage due to environmental changes can be simply and easily discriminated by means of solid-state NMR, without actually carrying out a test on environmental changes through trial and error, and therefore it is industrially highly useful.

## Claims

1. A method for discriminating a polymer compound membrane, the method comprising selecting a polymer compound membrane which shows little time-dependent change in a relaxation time (T1ρ) when the T1ρ of the polymer compound membrane has been measured by using a solid-state NMR device with a magnetic field strength of 7.05 Tesla.

2. The method for discriminating a polymer compound membrane according to claim 1, wherein each T1ρ is a T1ρ (ms) of a 13C nucleus at a temperature of 80°C measured by using a solid-state NMR device with a magnetic field strength of 7.05 Tesla, the method comprising selecting a polymer compound membrane in which the coefficient a of formula (1) satisfies formula (2) when the change in the T1ρ (ms) relative to a time t (hour) having elapsed since the start of measurement is represented by formula (1):

$$T1\rho = a \times \ln(t) + b \qquad (1)$$

$$0 \leq a \leq 25 \qquad (2).$$

3. A polymer compound membrane, wherein the coefficient a of formula (1) satisfies formula (2) when the T1ρ (ms) of the polymer compound membrane at a temperature of 80°C is measured by using a solid-state NMR device with a magnetic field strength of 7.05 Tesla, and the change in the T1ρ (ms) relative to a time t (hour) having elapsed since the start of measurement is represented by formula (1):

$$T1\rho = a \times \ln(t) + b \qquad (1)$$

$$0 \leq a \leq 25 \qquad (2).$$

4. The polymer compound membrane according to claim 3 comprising a polymer compound to constitute an engineering plastic.

5. The polymer compound membrane according to claim 3 or 4 comprising a polymer having an ion-exchange group.

6. The polymer compound membrane according to any one of claims 3 to 5 comprising a block copolymer comprising at least one block having an ion-exchange group and at least one block having no ion-exchange group.

7. The polymer compound membrane according to any one of claims 3 to 6 comprising a block copolymer comprising one or more blocks having an aromatic group in the main chain or a side chain and having an ion-exchange group, and one or more blocks having an aromatic group in the main chain or a side chain and having no ion-exchange group.

8. The polymer compound membrane according to any one of claims 3 to 7, containing a polyarylene-based block copolymer comprising one or more blocks having at least one kind of ion-exchange group selected from the group consisting of a phosphonic acid group, a carboxylic acid group, a sulfonic acid group, and a sulfonimide group, and one or more blocks having no ion-exchange group.

9. A method for producing a polymer electrolyte membrane, the method comprising applying a solution comprising a polymer electrolyte to a substrate by cast-application and removing a solvent to obtain the polymer electrolyte membrane, wherein in the solvent-removing step, the specific humidity H of the atmosphere of the step is kept in a range satisfying $0.01 \leq H \leq 0.5$ and the Celsius temperature T of the atmosphere of the step is kept in a range satisfying formula (3):

$$100 \leq T \leq 160 \qquad (3).$$

**INTERNATIONAL SEARCH REPORT**

International application No.
PCT/JP2009/054986

A. CLASSIFICATION OF SUBJECT MATTER
*G01N24/08*(2006.01)i, *C08J5/22*(2006.01)i

According to International Patent Classification (IPC) or to both national classification and IPC

B. FIELDS SEARCHED

Minimum documentation searched (classification system followed by classification symbols)
G01N24/00-24/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)
JSTPlus/JMEDPlus/JST7580(JDreamII)

C. DOCUMENTS CONSIDERED TO BE RELEVANT

| Category* | Citation of document, with indication, where appropriate, of the relevant passages | Relevant to claim No. |
|---|---|---|
| X | SEUNG-YEOP KWAK et al., Dynamic Mechanical and Solid-State NMR Determination of Molecular-Scale Heterogeneity in a Raw Elastomer, a Microcrystalline Polymer, and Their Blend, J.Polym.Sci.Part B, 1997, Vol.35 No.4, pp.709-716 | 1-2 |
| A | Seung-Yeop Kwak et al., CP/MAS 13C n.m.r. analysis of micromorphology in a thermoplastic elastomer prepared from nitrile rubber and poly(vinyl chloride), Polymer, 1996, Vol.37 No.2, pp.195-199 | 1-2 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 02 June, 2009 (02.06.09) | 16 June, 2009 (16.06.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

INTERNATIONAL SEARCH REPORT

International application No.
PCT/JP2009/054986

C (Continuation). DOCUMENTS CONSIDERED TO BE RELEVANT

| Category* | Citation of document, with indication, where appropriate, of the relevant passages | Relevant to claim No. |
|---|---|---|
| A | WO 2007/043274 A1 (Sumitomo Chemical Co., Ltd.),<br>19 April, 2007 (19.04.07),<br>Full text; all drawings<br>& JP 2007-284653 A & US 2008/0287646 A1<br>& EP 1935916 A1 & CA 2625339 A<br>& KR 10-2008-0059295 A | 1-2 |
| A | JP 8-122284 A (Asahi Chemical Industry Co., Ltd.),<br>17 May, 1996 (17.05.96),<br>Full text; all drawings<br>(Family: none) | 1-2 |
| A | JP 2003-166957 A (Toyota Motor Corp.),<br>13 June, 2003 (13.06.03),<br>Full text; all drawings<br>(Family: none) | 1-2 |

Form PCT/ISA/210 (continuation of second sheet) (April 2007)

**INTERNATIONAL SEARCH REPORT**

International application No.
PCT/JP2009/054986

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:
See extra sheet.

1. ☐ As all required additional search fees were timely paid by the applicant, this international search report covers all searchable claims.
2. ☐ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.:
Claims 1 and 2.

**Remark on Protest** the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

INTERNATIONAL SEARCH REPORT

International application No.
PCT/JP2009/054986

Continuation of Box No.III of continuation of first sheet(2)

The technical feature of the inventions of claims 1 and 2 is a method for discriminating a polymer compound film based on a relaxation time (T1ρ).

The technical feature of the inventions of claims 3 to 8 is a polymer compound film per se.

Here, the inventions of claims 3 to 8 relate to an invention of a product of "polymer compound film", and the method for discrimination per se by the relaxation time (T1ρ) does not limit the structure of the polymer compound film per se. Accordingly, the method for discrimination cannot be said to be a special technical feature.

The inventions of claims 3 to 8 cannot be distinguished from polymer compounds stated, for example, in WO 2007/043274 A1 (Sumitomo Chemical Co., Ltd.) 19 April, 2007 (19.04.07) and thus neither appear to be novel nor appear to involve an inventive step.

The technical feature of the invention of claim 9 is a process for producing a polymer electrolyte film comprising a predetermined solvent removing step.

There is no technical relationship among the above inventions involving one or more of the same or corresponding special technical features. Thus, the inventions are not so linked as to form a single general inventive concept.

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2007043274 A